# EUROPEAN PATENT SPECIFICATION

(11) **EP 3 038 083 B1**
(45) Date of publication and mention of the grant of the patent: **01.05.2019**
(21) Application number: 15178299.2
(22) Date of filing: 24.07.2015
(51) Int. Cl.: G09G 3/20, G09G 3/32

(54) **ORGANIC LIGHT EMITTING DIODE DISPLAY AND METHOD FOR DRIVING THE SAME**
ANZEIGE MIT ORGANISCHEN LICHTEMITTIERENDEN DIODEN UND VERFAHREN ZUR ANSTEUERUNG DAVON
AFFICHAGE À DIODE ÉLECTROLUMINESCENTE ORGANIQUE ET SON PROCÉDÉ DE COMMANDE

(30) Priority: 24.12.2014 KR 20140188899
(43) Date of publication of application: 29.06.2016
(73) Proprietor: LG Display Co., Ltd., Yeongdeungpo-gu Seoul 150-721 (KR)
(72) Inventor: LEE, Joonhee, Korea 140-713 (KR); KIM, Sunghoon, Korea 413-958 (KR); PARK, Jongmin, Korea 431-760 (KR)
(74) Representative: Jackson, Richard Eric

(56) References cited:
- US-A1- 2002 140 364
- US-A1- 2004 041 754
- US-A1- 2004 095 364
- US-A1- 2004 217 932
- US-A1- 2009 278 869
- US-A1- 2015 279 259

## Description

This application claims the benefit of Korea Patent Application No. 10-2014-0188899 filed on December 24, 2014, which is incorporated herein by reference for all purposes as if fully set forth herein.

### BACKGROUND OF THE INVENTION

### Field of the Invention

Embodiments of the invention relate to an organic light emitting diode display driven through a digital driving method and a method for driving the same.

### Discussion of the Related Art

Because an organic light emitting diode display (hereinafter, referred to as "OLED display") is a self-emission display device, the OLED display may be manufactured to have lower power consumption and thinner profile than a liquid crystal display requiring a backlight unit. Further, the OLED display has advantages of a wide viewing angle and a fast response time and thus has expanded its market while competing with the liquid crystal display.

The OLED display is driven through an analog voltage driving method or a digital driving method and may represent grayscale of an input image. The analog voltage driving method adjusts a data voltage applied to pixels based on data gray values of the input image and adjusts a luminance of the pixels based on a magnitude of the data voltage, thereby representing grayscale of the input image. The digital driving method adjusts an emission time of the pixels based on the data gray values of the input image, thereby representing grayscale of the input image.

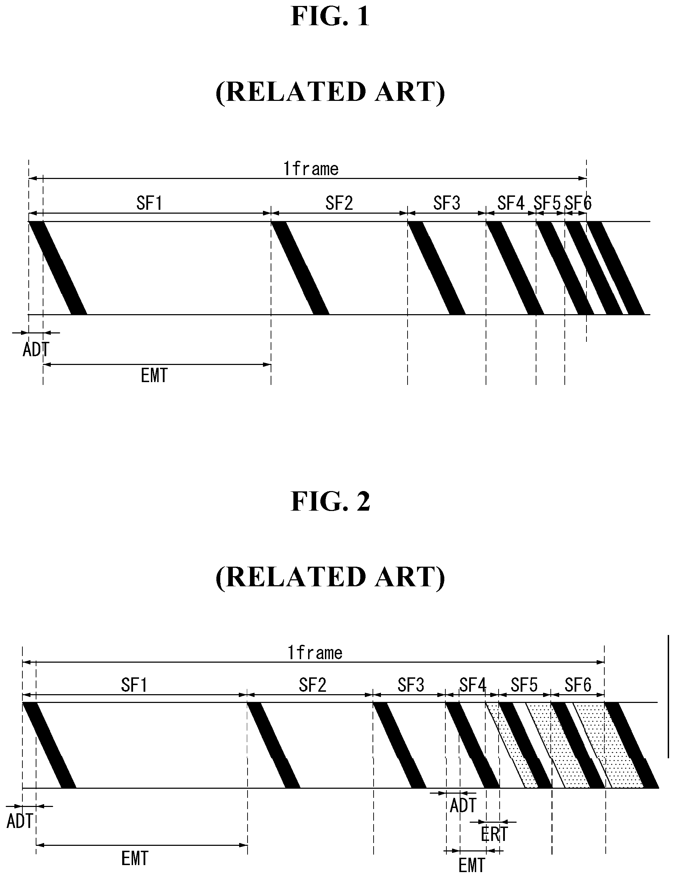

As shown in FIGS. 1 and 2, the digital driving method time-divides one frame into a plurality of subframes SF1 to SF6. Each subframe represents one bit of input image data. As shown in FIG. 1, each subframe may be divided into an address time ADT, during which data is written on pixels, and an emission time EMT, during which the pixels emit light. As shown in FIG. 2, each subframe may further include an erase time ERT, during which the pixels are turned off, in addition to the address time ADT and the emission time EMT. The emission times of the subframes may have different lengths. However, because a data addressing speed of the subframes is uniformly maintained as a reference value, the emission time of the same subframe is uniform irrespective of a position of the display panel.

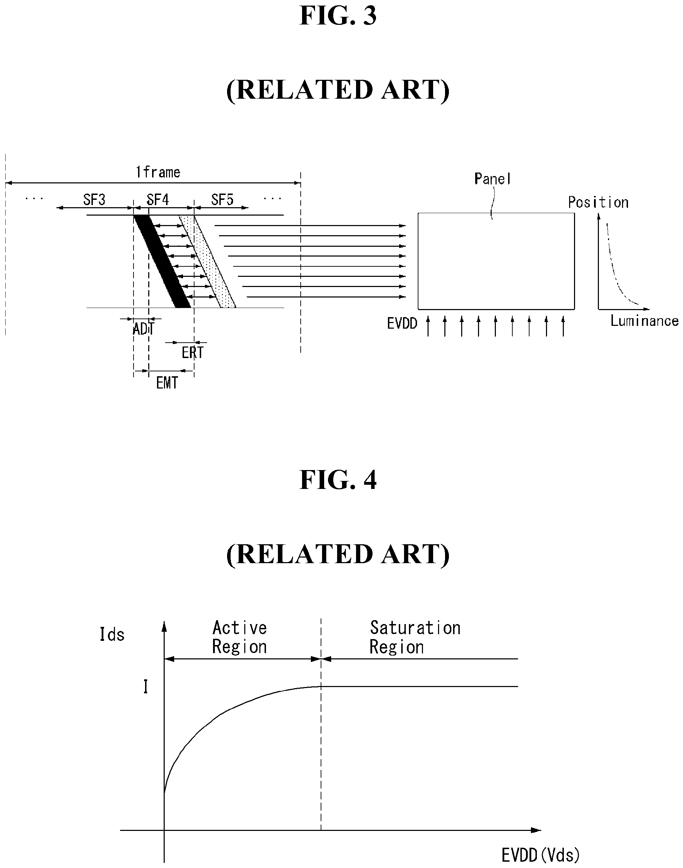

As shown in FIG. 3, because IR drop resulting from a line resistance is generated in the display panel, a high potential power voltage EVDD varies depending on a spatial position of the display panel to thereby generate a luminance deviation. The luminance implemented in the display panel decreases as the display panel is far from an input terminal of the high potential power voltage EVDD.

In the analog voltage driving method, a driving thin film transistor (TFT) is driven in a saturation region. As shown in FIG. 4, the saturation region indicates a voltage region, in which a drain-source current Ids does not substantially change depending on a drain-source voltage Vds of the driving TFT, and is positioned on the right side of the Vds-Ids plane. In other words, in the saturation region, the drain-source current Ids does not change although the high potential power voltage EVDD (i.e., the drain-source voltage Vds of the driving TFT) changes.

On the other hands, in the digital driving method, the driving TFT is driven in an active region, so as to reduce power consumption. As shown in FIG. 4, the active region indicates a voltage region, in which the drain-source current Ids changes depending on the drain-source voltage Vds of the driving TFT, and is positioned on the left side of the Vds-Ids plane. In other words, in the active region, the drain-source current Ids sensitively changes depending on changes in the high potential power voltage EVDD (i.e., the drain-source voltage Vds of the driving TFT).

For this reason, the luminance deviation resulting from the IR drop is more of a problem in the digital driving method than the analog voltage driving method. US2002140364A1 relates to a light emitting device which is capable of displaying a high gradation image while preventing the drive frequency of a source signal line driving circuit from increasing. One pixel has a plurality of sub-pixels each having the same area of effective light emission. Sub-frame periods in each of the sub-pixels are all used to control the gradation of the corresponding pixel. The present light emitting device can operate as follows when, for example, adopting time gradation according to binary code. A sub-frame period for a specific bit is divided into a plurality of sub-frame periods, and a sub-frame for another bit or a period in which no image is displayed (non-display period) is interspersed between the divided sub-frame periods, not successively starting the divided sub-frame periods. In a non-display period, light emitting, elements in all of the pixels in the pixel portion do not emit light.

### SUMMARY OF THE INVENTION

The present invention is defined by the independent claims with further details of specific embodiments being provided by the dependent claims.

Accordingly, embodiments of the invention provide an organic light emitting diode display driven through a digital driving method and a method for driving the same capable of minimizing a luminance deviation resulting from IR drop.

In one aspect, there is an organic light emitting diode display comprising a display panel including a plurality of pixels, a display panel driver configured to drive signal lines of the display panel, and a timing controller configured to divide one frame into a plurality of subframes, divide data of an input image at each bit, map the data of the input image to the plurality of subframes, control an operation of the display panel driver, and adjust data addressing speeds of the plurality of subframes for differently adjusting the emission times of the upper and lower display lines of the display panel.

The timing controller adjusts the data addressing speed of at least one subframe of the plurality of subframes differently from a previously determined reference value.

When a high potential power voltage for driving the pixels is applied to the display panel from an upper side of the display panel and data addressing is sequentially performed from the upper side to a lower side of the display panel in a sequential line manner, the timing controller reduces the data addressing speed as it goes from a first subframe to a last subframe of the one frame, wherein the most significant bit (MSB) of the data will be mapped to the first subframe, and the least significant bit (LSB) of the data will be mapped to the last subframe.

When a high potential power voltage for driving the pixels is applied to the display panel from a lower side of the display panel and data addressing is sequentially performed from an upper side to the lower side of the display panel in a sequential line manner, the timing controller increases the data addressing speed as it goes from a first subframe to a last subframe of the one frame, wherein the most significant bit (MSB) of the data will be mapped to the first subframe, and the least significant bit (LSB) of the data will be mapped to the last subframe.

The timing controller includes a multiplexer configured to receive a plurality of gate shift clocks having different pulse periods and selectively output one of the plurality of gate shift clocks to the display panel driver at start timing of each subframe.

A dummy subframe is further arranged after the last subframe in the one frame. A length of the dummy subframe at an upper display line of the display panel is different from a length of the dummy subframe at a lower display line of the display panel.

The display panel driver applies a data voltage, which causes the pixels not to emit light, to the display panel during the dummy subframe.

In another aspect, there is a method for driving an organic light emitting diode display including a display panel including a plurality of pixels and a display panel driver driving signal lines of the display panel, the method comprising dividing one frame into a plurality of subframes, dividing data of an input image at each bit, and mapping the data of the input image to the plurality of subframes, and controlling an operation of the display panel driver and adjusting data addressing speeds of the plurality of subframes for differently adjusting the emission times of the upper and lower display lines of the display panel.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIGS. 1 and 2 illustrate a related art digital driving method;
FIG. 3 shows that a luminance deviation resulting from IR drop is generated depending on a position of a display panel;
FIG. 4 shows a graph indicating operating characteristics of a driving thin film transistor (TFT);
FIGS. 5 and 6 show an organic light emitting diode display according to an exemplary embodiment of the invention;
FIG. 7 is a circuit diagram showing one pixel of the organic light emitting diode display shown in FIG. 6;
FIG. 8 shows an example of adjusting a data addressing speed so as to minimize a luminance deviation resulting from IR drop;
FIG. 9 shows a luminance distribution depending on a position of a display panel before and after the application of FIG. 8;
FIG. 10 shows another example of adjusting a data addressing speed so as to minimize a luminance deviation resulting from IR drop;
FIG. 11 shows a luminance distribution depending on a position of a display panel before and after the application of FIG. 10;
FIG. 12 shows a multiplexer adjusting a pulse period of a gate shift clock in each subframe so as to adjust a data addressing speed;
FIGS. 13A to 13D show a gate shift clock assigned to each of first to fourth subframes shown in FIG. 10 and scan pulses based on the gate shift clock; and
FIG. 14 shows frame configuration of an organic light emitting diode display further including a dummy subframe in one frame.

### DETAILED DESCRIPTION OF THE ILLUSTRATED EMBODIMENTS

Reference will now be made in detail to embodiments of the invention, examples of which are illustrated in the accompanying drawings. Wherever possible, the same reference numbers will be used throughout the drawings to refer to the same or like parts. It will be paid attention that detailed description of known arts will be omitted if it is determined that the arts can mislead the embodiments of the invention.

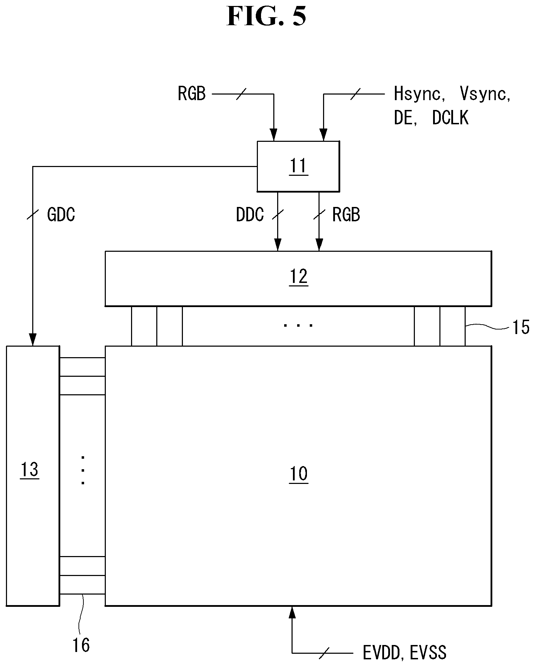

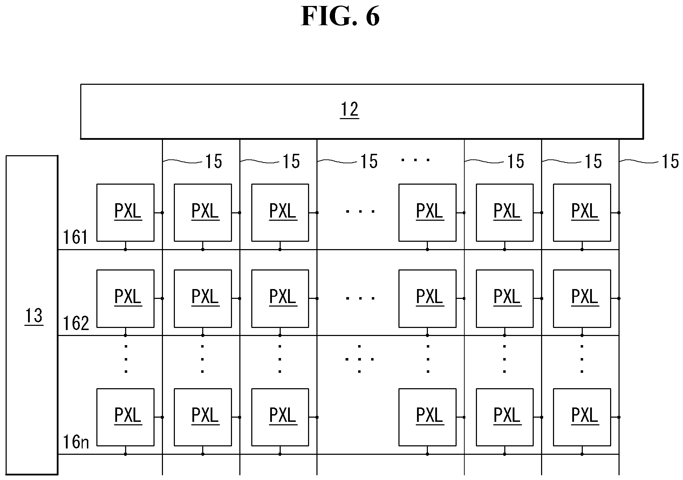

FIGS. 5 to 7 show an organic light emitting diode display (hereinafter, referred to as "OLED display") according to an exemplary embodiment of the invention.

Referring to FIGS. 5 to 7, the OLED display according to the embodiment of the invention includes a display panel 10, display panel drivers 12 and 13 for writing pixel data of an input image on a pixel array of the display panel 10, and a timing controller 11 for controlling the display panel drivers 12 and 13.

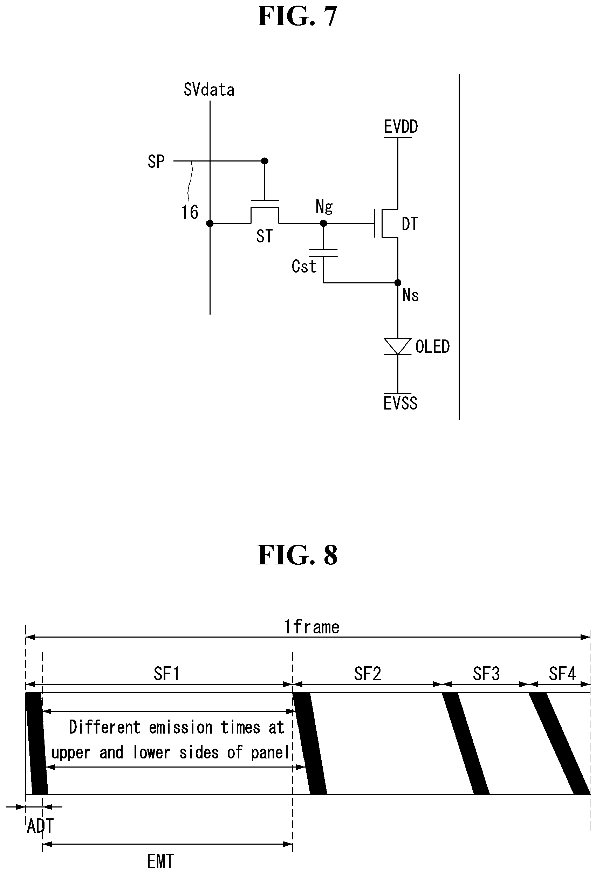

On the pixel array of the display panel 10, a plurality of data lines 15 and a plurality of scan lines (or gate lines) 16 cross each other. The pixel array of the display panel 10 includes pixels PXL, that are arranged in a matrix form and display the input image. Each pixel PXL may be one of a red (R) pixel, a green (G) pixel, a blue (B) pixel, and a white (W) pixel. As shown in FIG. 7, each pixel PXL may include a plurality of thin film transistors (TFTs), an organic light emitting diode (OLED), a capacitor, and the like.

The display panel drivers 12 and 13 include a data driver 12 and a gate driver 13.

The data driver 12 generates a data voltage SVdata based on data RGB of the input image received from the timing controller 11 and outputs the data voltage SVdata to the data lines 15. In a digital driving method, an amount of light emitted by the pixels PXL is uniform, and grayscale of the data RGB is represented through an amount of emission time, during which the pixels PXL emit light. Therefore, the data driver 12 selects one of a voltage satisfying an emission condition of the pixels PXL and a voltage not satisfying the emission condition of the pixels PXL depending on digital values of the data RGB mapped to the subframe and generates the data voltage SVdata.

The gate driver 13 sequentially supplies a scan pulse (or a gate pulse) SP synchronized with the data voltage SVdata of the data driver 12 to the scan lines 16 (i.e., 161 to 16n) under the control of the timing controller 11. The gate driver 13 sequentially shifts the scan pulse SP and sequentially selects the pixels PXL, to which the data voltage SVdata is applied, on a per line basis.

The timing controller 11 receives the pixel data RGB of the input image and timing signals synchronized with the pixel data RGB from a host system (not shown). The timing controller 11 controls operation timing of the data driver 12 and operation timing of the gate driver 13 based on the timing signals synchronized with the pixel data RGB of the input image and synchronizes the data driver 12 and the gate driver 13. The timing signals include a vertical sync signal Vsync, a horizontal sync signal Hsync, a data enable signal DE, a dot clock DCLK, and the like. The timing controller 11 generates a source timing control signal DDC controlling the operation timing of the data driver 12 and a gate timing control signal GDC controlling the operation timing of the gate driver 13.

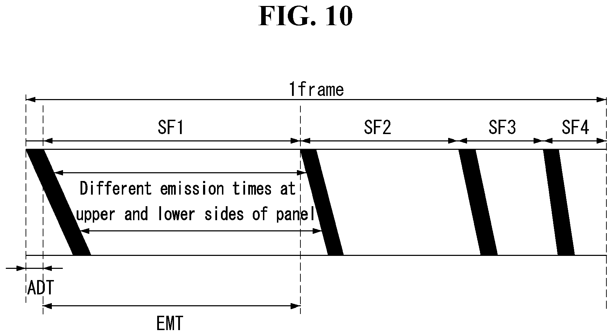

The timing controller 11 controls the display panel drivers 12 and 13 through the digital driving method. The timing controller 11 divides one frame into a plurality of subframes. Each subframe represents one bit of the data of the input image. As shown in FIGS. 8, 10, and 14, each subframe includes an address time ADT, during which the data is written on the pixels PXL, and an emission time EMT, during which the pixels PXL emit light. As shown in FIGS. 8 and 10, lengths of the emission times EMT of the subframes may be differently set depending on a data bit of the input image. For example, the most significant bit (MSB) represents a high gray level and thus may be mapped to the subframe having the long emission time, and the least significant bit (LSB) represents a low gray level and thus may be mapped to the subframe having the small emission time. The timing controller 11 maps the data RGB of the input image to the subframe at each bit and transmits the data RGB to the data driver 12.

The timing controller 11 controls operations of the display panel drivers 12 and 13 and adjusts data addressing speeds of the subframes. Hence, the timing controller 11 differently adjusts emission times of upper and lower display lines of the display panel 10 and can suppress a luminance deviation resulting from IR drop depending on a position of the display panel 10.

The timing controller 11 may adjust the data addressing speed of at least one subframe of the plurality of subframes differently from a previously determined reference value and may differently adjust the emission times of the upper and lower display lines of the display panel 10. Further, the timing controller 11 may gradually increase or reduce the data addressing speed as it goes from a first subframe to a last subframe of the plurality of subframes, thereby differently adjusting the emission times of the upper and lower display lines of the display panel 10.

The host system may be implemented as one of a television system, a set-top box, a navigation system, a DVD player, a Blu-ray player, a personal computer (PC), a home theater system, and a phone system.

As shown in FIG. 7, each pixel PXL includes an OLED, a driving TFT DT, a switching TFT ST, a storage capacitor Cst, and the like.

The OLED has a stack structure of organic compound layers including a hole injection layer HIL, a hole transport layer HTL, an emission layer EML, an electron transport layer ETL, an electron injection layer EIL, etc. The OLED generates light when electrons and holes combine in the emission layer EML.

The driving TFT DT operates in the active region shown in FIG. 4 and makes the OLED emit light. The driving TFT DT is connected between a power line, to which a high potential power voltage EVDD is supplied, and the OLED and switches on or off a current flowing in the OLED depending on the data voltage SVdata applied to a gate node Ng.

The switching TFT ST is turned on in response to the scan pulse SP from the scan line 16. The switching TFT ST supplies the data voltage SVdata to the gate node Ng in response to the scan pulse SP.

The storage capacitor Cst maintains a gate-source voltage Vgs of the driving TFT DT. The storage capacitor Cst maintains the data voltage SVdata applied to the gate node Ng of the driving TFT DT and keeps the emission of the OLED.

Each pixel PXL of the display panel 10 according to the embodiment of the invention is not limited to the structure shown in FIG. 7 and may have any pixel structure capable of performing the digital driving method.

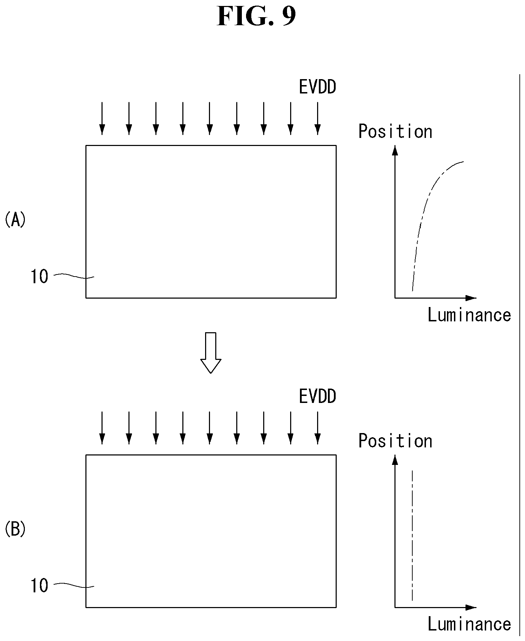

FIG. 8 shows an example of adjusting the data addressing speed so as to minimize the luminance deviation resulting from the IR drop. FIG. 9 shows a luminance distribution depending on the position of the display panel before and after the application of FIG. 8.

As shown in FIG. 9, in the OLED display according to the embodiment of the invention, the high potential power voltage EVDD for driving the pixels is applied to the display panel 10 from the upper side of the display panel 10, and the data addressing may be sequentially performed from the upper side to the lower side of the display panel 10 in a sequential line manner. In this instance, as shown in (A) of FIG. 9, the luminance deviation resulting from the IR drop depending on the position of the display panel may be generated.

As shown in FIG. 8, as it goes from the first subframe SF1, to which the most significant bit (MSB) of the pixel data RGB will be mapped, to the last subframe SF4, to which the least significant bit (LSB) of the pixel data RGB will be mapped, the timing controller 11 gradually reduces the data addressing speed so as to suppress the luminance deviation. The timing controller 11 causes the emission time EMT at the lower side of the display panel 10 relatively far from an input terminal of the high potential power voltage EVDD to be longer than the emission time EMT at the upper side of the display panel 10 relatively close to the input terminal of the high potential power voltage EVDD by adjusting the data addressing speed as described above.

In the digital driving method, the grayscale of the input image is represented through changes in the length of the emission time EMT. Therefore, an increase in the emission time EMT increases the luminance. Thus, as shown in (B) of FIG. 9, the luminance deviation resulting from the IR drop depending on the position of the display panel 10 is minimized, and the uniform luminance may be implemented irrespective of the upper and lower sides of the display panel.

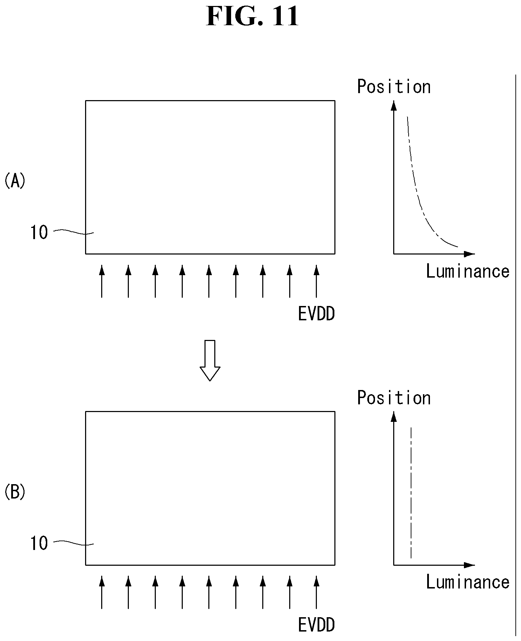

FIG. 10 shows another example of adjusting the data addressing speed so as to minimize the luminance deviation resulting from the IR drop. FIG. 11 shows a luminance distribution depending on the position of the display panel before and after the application of FIG. 10.

As shown in FIG. 11, in the OLED display according to the embodiment of the invention, the high potential power voltage EVDD for driving the pixels is applied to the display panel 10 from the lower side of the display panel 10, and the data addressing may be sequentially performed from the upper side to the lower side of the display panel 10 in the sequential line manner. In this instance, as shown in (A) of FIG. 11, the luminance deviation resulting from the IR drop depending on the position of the display panel may be generated.

As shown in FIG. 10, as it goes from the first subframe SF1, to which the most significant bit (MSB) of the pixel data RGB will be mapped, to the last subframe SF4, to which the least significant bit (LSB) of the pixel data RGB will be mapped, the timing controller 11 gradually increases the data addressing speed so as to suppress the luminance deviation. The timing controller 11 causes the emission time EMT at the upper side of the display panel 10 relatively far from the input terminal of the high potential power voltage EVDD to be longer than the emission time EMT at the lower side of the display panel 10 relatively close to the input terminal of the high potential power voltage EVDD by adjusting the data addressing speed as described above.

In the digital driving method, the grayscale of the input image is represented through changes in the length of the emission time EMT. Therefore, an increase in the emission time EMT increases the luminance. Thus, as shown in (B) of FIG. 11, the luminance deviation resulting from the IR drop depending on the position of the display panel 10 is minimized, and the uniform luminance may be implemented irrespective of the upper and lower sides of the display panel.

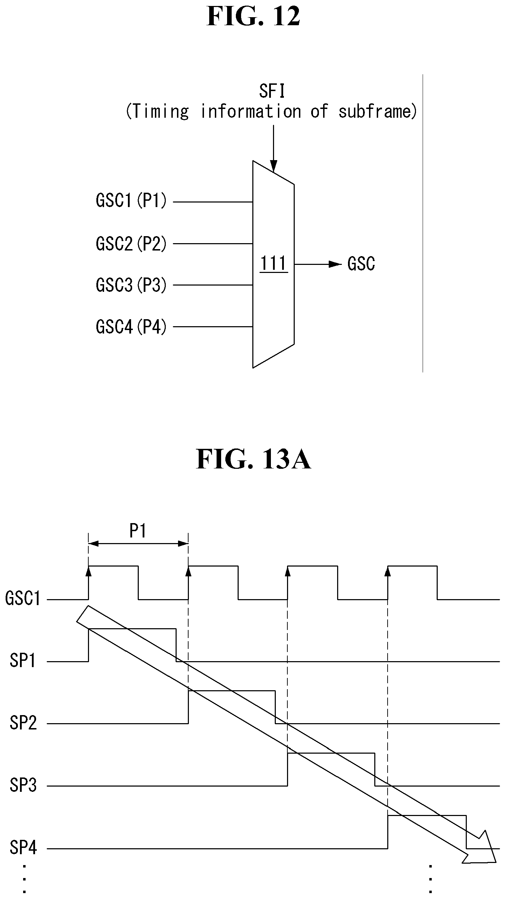

FIG. 12 shows a multiplexer adjusting a pulse period of a gate shift clock in each subframe so as to adjust the data addressing speed.

The timing controller 11 adjusts a pulse period of a gate shift clock in each subframe so as to adjust the data addressing speed. Because a length of each subframe is previously determined depending on a data bit of the pixel data RGB of the input image, the timing controller 11 may count the timing signals (for example, gate start pulses) capable of defining one frame and produce subframe timing information SFI indicating a start of each subframe of one frame. The timing controller 11 may generate a plurality of gate shift clocks GSC1 to GSC4 having different pulse periods P1 to P4. The gate shift clocks GSC1 to GSC4 are clock signals for shifting the gate start pulse. The gate start pulse controls generation timing of a first gate pulse in one frame.

A multiplexer 111 selectively outputs one of the gate shift clocks GSC1 to GSC4 based on the subframe timing information SFI. In other words, the multiplexer 111 selectively outputs one of the gate shift clocks GSC1 to GSC4 to the display panel driver (i.e., the gate driver 13) at the start timing of each subframe. A width of the scan pulse produced by the gate driver 13 is determined depending on the pulse period of the gate shift clock. The multiplexer 111 may be embedded in the timing controller 11.

The gate driver 13 produces scan pulses shown in FIGS. 13A to 13D based on the gate shift clocks GSC1 to GSC4. FIGS. 13A to 13D show a gate shift clock assigned to each of the first to fourth subframes shown in FIG. 10 and scan pulses based on the gate shift clock.

For example, as shown in FIG. 13A, the gate driver 13 produces first scan pulses SP1-SP4, ... which have a first pulse width due to the first gate shift clock GSC1 having the first pulse period P1 and are sequentially shifted, in the first subframe SF1 so as to adjust the data addressing speed shown in FIG. 10.

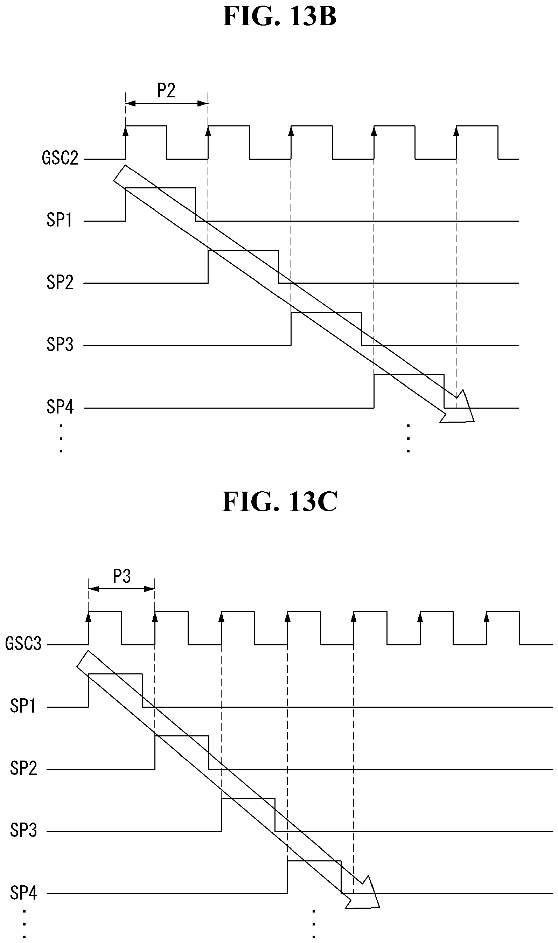

As shown in FIG. 13B, the gate driver 13 produces second scan pulses SP1-SP4, ... which have a second pulse width less than the first pulse width due to the second gate shift clock GSC2 having the second pulse period P2 shorter than the first pulse period P1 and are sequentially shifted, in the second subframe SF2 following the first subframe SF1. The data addressing speed of the second subframe SF2 is faster than the data addressing speed of the first subframe SF1 due to the second scan pulses SP1-SP4, ...

As shown in FIG. 13C, the gate driver 13 produces third scan pulses SP1-SP4, ... which have a third pulse width less than the second pulse width due to the third gate shift clock GSC3 having the third pulse period P3 shorter than the second pulse period P2 and are sequentially shifted, in the third subframe SF3 following the second subframe SF2. The data addressing speed of the third subframe SF3 is faster than the data addressing speed of the second subframe SF2 due to the third scan pulses SP1-SP4, ...

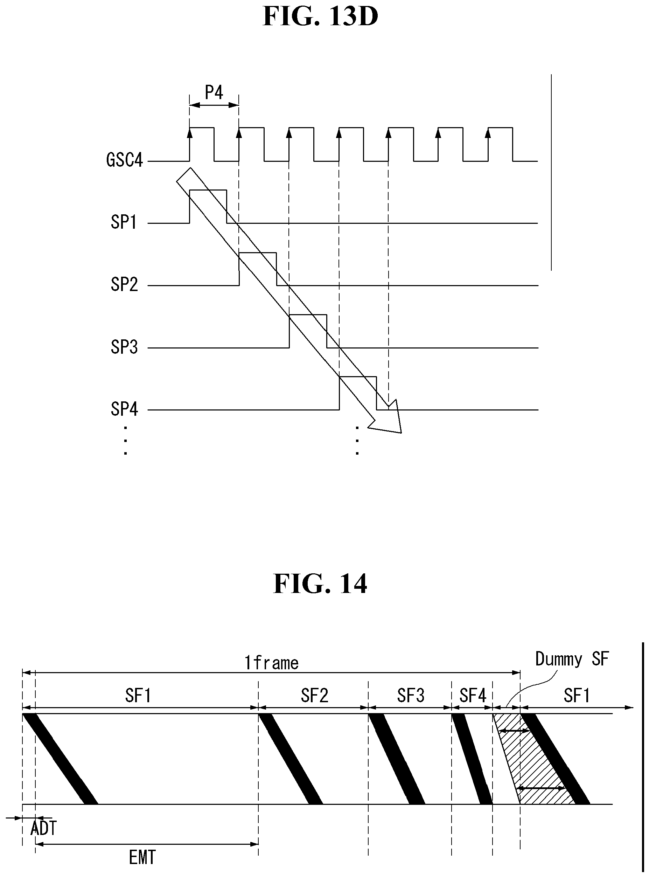

As shown in FIG. 13D, the gate driver 13 produces fourth scan pulses SP1-SP4, ... which have a fourth pulse width less than the third pulse width due to the fourth gate shift clock GSC4 having the fourth pulse period P4 shorter than the third pulse period P3 and are sequentially shifted, in the fourth subframe SF4 following the third subframe SF3. The data addressing speed of the fourth subframe SF4 is faster than the data addressing speed of the third subframe SF3 due to the fourth scan pulses SP1-SP4, ...

FIG. 14 shows frame configuration of the OLED display further including a dummy subframe in one frame.

The data addressing speed may be equally adjusted in each frame for easier luminance control. For example, the data addressing speed of the first subframe is equally adjusted in all the frames, and the data addressing speed of the second subframe is equally adjusted in all of the frames. It is a matter of course that the data addressing speed of the first subframe may be different from the data addressing speed of the second subframe.

There is still a problem in that emission times of the upper and lower display lines of the display panel in one subframe are different from each other, but the total emission times of all the display lines of the display panel during one frame are the same as one another through the adjustment of the data addressing speed.

Hence, as shown in FIG. 14, the embodiment of the invention further includes a dummy subframe SF after the last subframe SF4 in one frame. A length of the dummy subframe SF at the upper display line of the display panel is different from a length of the dummy subframe SF at the lower display line of the display panel.

The timing controller 11 controls operations of the data driver 12 and the gate driver 13 and adjusts data applied to the display panel 10 and an addressing speed of the data during the dummy subframe SF. The data driver 12 applies the data voltage, which causes the pixels not to emit light, to the display panel 10 under the control of the timing controller 11 during the dummy subframe SF.

The timing controller 11 may cause the data addressing speed of the dummy subframe SF to be the same as or different from the data addressing speed of the last subframe SF4, so that the total emission times of the upper and lower display lines of the display panel during one frame are different from each other.

As an example, when the data addressing speed of at least one of the remaining subframes SF2 to SF4 except the first subframe SF1 is faster than the data addressing speed of the first subframe SF1, the timing controller 11 may cause the data addressing speed of the dummy subframe SF to be the same as or faster than the data addressing speed of the last subframe SF4.

As another example, when the data addressing speed of at least one of the remaining subframes SF2 to SF4 except the first subframe SF1 is slower than the data addressing speed of the first subframe SF1, the timing controller 11 may cause the data addressing speed of the dummy subframe SF to be the same as or slower than the data addressing speed of the last subframe SF4.

As described above, the embodiment of the invention can minimize the luminance deviation resulting from the IR drop by differently adjusting the emission times of the upper and lower display lines of the display panel. The embodiment of the invention further arranges the dummy subframe at the last part of each frame and differently adjusts the length of the dummy subframe at the upper and lower display lines of the display panel, thereby efficiently controlling the emission time.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. An organic light emitting diode (OLED) display comprising:
a display panel (10) including a plurality of pixels (PIX), a plurality of data lines (15) and a plurality of scan lines (16); a data driver (12) configured to generate data voltages and output the data voltages to the data lines of the display panel;
a gate driver (13) configured to sequentially supply a scan pulse to the scan lines in response to a gate shift clock; and a timing controller (11) configured to:
divide one frame into a plurality of subframes,
divide data of an input image at each bit,
map the data of the input image to the plurality of subframes, each subframe representing one bit of the data of the input image, the scan line of the display panel being addressed in a said subframe such that the addressing of pixels of each scan line includes:
a data address time (ADT) during which data voltage are written on the pixels of said scan line; and
an emission time (EMT) during which the pixels (PXL) of the scan line emit light in response to said written data voltages;
and to
control an operation of the data and gate drivers wherein the timing controller is configured to synchronize the operation timings of the output of said data voltages to said data lines and the sequential supply of said scan pulse to said scan lines,
**characterized in that** the timing controller is further configured to adjust a period of said gate shift clock for at least one subframe of the frame to thereby adjust the data addressing speed of said at least one subframe with respect to the data addressing speed of the previous subframe of said frame wherein the duration of the data addressing time (ADT) of each scan line for said at least one subframe is different from that of the data addressing time (ADT) for each scan line of said previous subframe, and whereby the resulting emission times (EMT) of the upper scan lines of the display panel for said previous subframe differ from the resulting emission times (EMT) of the lower scan lines of the display panel.

2. The organic light emitting diode display according to claim 1, wherein the timing controller adjusts the data addressing speed of the at least one subframe of the plurality of subframes to be different from a previously determined reference value.

3. The organic light emitting diode display according to claim 1, wherein when a high potential power voltage (EVDD) for driving the pixels is applied to the display panel from an upper side of the display panel and data addressing is sequentially performed from the upper side to a lower side of the display panel in a sequential line manner, the timing controller reduces the data addressing speed as it goes from a first subframe to a last subframe of the one frame,
wherein the most significant bit (MSB) of the data will be mapped to the first subframe, and the least significant bit (LSB) of the data will be mapped to the last subframe.

4. The organic light emitting diode display according to claim 1, wherein when a high potential power voltage (EVDD) for driving the pixels is applied to the display panel from a lower side of the display panel and data addressing is sequentially performed from an upper side to the lower side of the display panel in a sequential line manner, the timing controller increases the data addressing speed as it goes from a first subframe to a last subframe of the one frame,
wherein the most significant bit (MSB) of the data will be mapped to the first subframe, and the least significant bit (LSB) of the data will be mapped to the last subframe.

5. The organic light emitting diode display according to any one of claims 1 to 4, wherein the timing controller includes a multiplexer (111) configured to receive a plurality of gate shift clocks (GSC1 to GSC4) having different pulse periods (P1 to P4) and selectively output one of the plurality of gate shift clocks to the gate driver (13) at start timing of each subframe.

6. The organic light emitting diode display according to any one of claims 1 to 5, wherein a dummy subframe (SF) is further arranged after the last subframe in the one frame, and
wherein a length of the dummy subframe at an upper display line of the display panel is different from a length of the dummy subframe at a lower display line of the display panel.

7. The organic light emitting diode display according to claim 6, wherein the data driver (12) applies a data voltage, which causes the pixels not to emit light, to the display panel during the dummy subframe.

8. A method for driving an organic light emitting diode (OLED) display including a display panel (10) including: a plurality of pixels (PIX), a plurality of data lines (15) and a plurality of scan lines (16); a data driver (12) configured to generate data voltages and output the data voltages to the data lines of the display panel;
a gate driver (13) configured to sequentially supply a scan pulse to the scan lines in response to a gate shift clock; and a timing controller,
the method comprising;
dividing one frame into a plurality of subframes (SF1 to SF6), dividing data of an input image at each bit, and mapping the data of the input image to the plurality of subframes, each subframe representing one bit of the data of the input image, each scan line of the display panel being addressed in a said subframe such that the addressing of pixels of each scan line of the display panel includes:
a data address time (ADT) during which data voltages are written on the pixels of said scan line; and
an emission time (EMT) during which the pixels (PXL) of the scan line emit light in response to the written data voltages ; and synchronizing the operation timings of the output of said data voltages to said data lines and the sequential supply of said scan pulse to said scan lines, **characterized in that** the method further comprises adjusting a period of said gate shift clock for at least one subframe of the frame to thereby adjust the data addressing speed of said at least one subframe with respect to the data addressing speed of the previous subframe of said frame, wherein the duration of the data addressing time (ADT) of each scan line for said at least one subframe is different from that of the data addressing time (ADT) for each scan line of said previous subframe, and whereby the resulting emission times (EMT) of the upper scan lines of the display panel for said previous subframe differ from the resulting emission times of the lower scan lines of the display panel.

9. The method according to claim 8, wherein the adjusting of the data addressing speeds includes adjusting the data addressing speed of the at least one subframe of the plurality of subframes to be different from a previously determined reference value.

10. The method according to claim 8, wherein when a high potential power voltage (EVDD) for driving the pixels is applied to the display panel from an upper side of the display panel and data addressing is sequentially performed from the upper side to a lower side of the display panel in a sequential line manner, the adjusting of the data addressing speeds includes reducing the data addressing speed as it goes from a first subframe to a last subframe of the one frame,
wherein the most significant bit (MSB) of the data will be mapped to the first subframe, and the least significant bit (LSB) of the data will be mapped to the last subframe.

11. The method according to claim 8, wherein when a high potential power voltage (EVDD) for driving the pixels is applied to the display panel from a lower side of the display panel and data addressing is sequentially performed from an upper side to the lower side of the display panel in a sequential line manner, the adjusting of the data addressing speeds includes increasing the data addressing speed as it goes from a first subframe to a last subframe of the one frame,
wherein the most significant bit (MSB) of the data will be mapped to the first subframe, and the least significant bit (LSB) of the data will be mapped to the last subframe.

12. The method according to any one of claims 8 to 11, wherein the adjusting of the data addressing speeds includes receiving a plurality of gate shift clocks (GSC1 to GSC4) having different pulse periods (P1 to P4) and selectively outputting one of the plurality of gate shift clocks to the gate driver (13) at start timing of each subframe.

13. The method according to any one of claims 8 to 12, wherein a dummy subframe is further arranged after the last subframe in the one frame, and
wherein a length of the dummy subframe at an upper display line of the display panel is different from a length of the dummy subframe at a lower display line of the display panel.

14. The method according to claim 13, further comprising applying a data voltage, which causes the pixels not to emit light, to the display panel during the dummy subframe.

## Patentansprüche

1. Anzeige mit organischen lichtemittierenden Dioden (OLED), aufweisend:
eine Anzeigetafel (10), die mehrere Pixel (PIX), mehrere Datenzeilen (15) und mehrere Abtastzeilen (16) enthält;
einen Datentreiber (12), der zum Erzeugen von Datenspannungen und Ausgeben der Datenspannungen an die Datenzeilen der Anzeigetafel konfiguriert ist;
einen Gatetreiber (13), der zum sequentiellen Zuführen eines Abtastimpulses zu den Abtastzeilen in Reaktion auf einen Gateschiebetakt konfiguriert ist; und
eine Timingsteuerung (11), konfiguriert zum:
Aufteilen eines Frames in mehrere Subframes,
Aufteilen von Daten eines Eingangsbilds an jedem Bit,
Abbilden der Daten des Eingangsbilds auf die mehreren Subframes, wobei jeder Subframe ein Bit der Daten des Eingangsbilds darstellt, wobei die Abtastzeile der Anzeigetafel in einem Subframe derart adressiert wird, dass das Adressieren von Pixeln jeder Abtastzeile beinhaltet:
eine Datenadressierzeit (ADT), während welcher Datenspannungen auf die Pixel der Abtastzeile geschrieben werden; und
eine Emissionszeit (EMT), während welcher die Pixel (PXL) der Abtastzeile in Reaktion auf die geschriebenen Datenspannungen Licht emittieren;
und zum
Steuern eines Betriebs der Daten- und Gatetreiber, wobei die Timingsteuerung zum Synchronisieren der Betriebstimings der Ausgabe der Datenspannungen an die Datenzeilen und der sequentiellen Zufuhr des Abtastimpulses zu den Abtastzeilen konfiguriert ist,
**dadurch gekennzeichnet, dass** die Timingsteuerung ferner zum Anpassen einer Periode des Gateschiebetakts für mindestens einen Subframe des Frames konfiguriert ist, um dadurch die Datenadressiergeschwindigkeit des mindestens einen Subframes bezüglich der Datenadressiergeschwindigkeit des vorherigen Subframes des Frames anzupassen, wobei die Dauer der Datenadressierzeit (ADT) jeder Abtastzeile für den mindestens einen Subframe von jener der Datenadressierzeit (ADT) für jede Abtastzeile des vorherigen Subframes abweicht, und wobei die resultierenden Emissionszeiten (EMT) der oberen Abtastzeilen der Anzeigetafel für den vorherigen Subframe von den resultierenden Emissionszeiten (EMT) der unteren Abtastzeilen der Anzeigetafel abweichen.

2. Anzeige mit organischen lichtemittierenden Dioden nach Anspruch 1, wobei die Timingsteuerung die Datenadressiergeschwindigkeit des mindestens einen Subframes der mehreren Subframes derart anpasst, dass sie von einem vorher festgelegten Bezugswert abweicht.

3. Anzeige mit organischen lichtemittierenden Dioden nach Anspruch 1, wobei, wenn eine Hochleistungsspannung (EVDD) zum Ansteuern der Pixel an die Anzeigetafel von einer Oberseite der Anzeigetafel angelegt und Datenadressierung sequentiell von der Oberseite zu einer Unterseite der Anzeigetafel folgezeilig ausgeführt wird, die Timingsteuerung die Datenadressiergeschwindigkeit reduziert, wie sie von einem ersten Subframe zu einem letzten Subframe des einen Frames läuft,
wobei das signifikanteste Bit (MSB) der Daten auf den ersten Subframe abgebildet wird und das insignifikanteste Bit (LSB) der Daten auf den letzten Subframe abgebildet wird.

4. Anzeige mit organischen lichtemittierenden Dioden nach Anspruch 1, wobei, wenn eine Hochleistungsspannung (EVDD) zum Ansteuern der Pixel an die Anzeigetafel von einer Unterseite der Anzeigetafel angelegt und Datenadressierung sequentiell von einer Oberseite zur Unterseite der Anzeigetafel folgezeilig ausgeführt wird, die Timingsteuerung die Datenadressiergeschwindigkeit erhöht, wie sie von einem ersten Subframe zu einem letzten Subframe des einen Frames läuft,
wobei das signifikanteste Bit (MSB) der Daten auf den ersten Subframe abgebildet wird und das insignifikanteste Bit (LSB) der Daten auf den letzten Subframe abgebildet wird.

5. Anzeige mit organischen lichtemittierenden Dioden nach einem der Ansprüche 1 bis 4, wobei die Timingsteuerung einen Multiplexer (111) enthält, der zum Empfangen von mehreren Gateschiebetakten (GSC1 bis GSC4) mit verschiedenen Impulsperioden (P1 bis P4) und selektiven Ausgeben von einem der mehreren Gateschiebetakte an den Gatetreiber (13) zur Startzeit von jedem Subframe konfiguriert ist.

6. Anzeige mit organischen lichtemittierenden Dioden nach einem der Ansprüche 1 bis 5, wobei ein Dummy-Subframe (SF) ferner nach dem letzten Subframe in dem einen Frame angeordnet ist, und
wobei eine Länge des Dummy-Subframes an einer oberen Anzeigezeile der Anzeigetafel von einer Länge des Dummy-Subframes an einer unteren Anzeigezeile der Anzeigetafel abweicht.

7. Anzeige mit organischen lichtemittierenden Dioden nach Anspruch 6, wobei der Datentreiber (12) eine Datenspannung, die bewirkt, dass die Pixel kein Licht emittieren, während des Dummy-Subframes an die Anzeigetafel anlegt.

8. Verfahren zum Ansteuern einer Anzeige mit organischen lichtemittierenden Dioden (OLED), enthaltend eine Anzeigetafel (10), welche enthält:
mehrere Pixel (PIX); mehrere Datenzeilen (15) und mehrere Abtastzeilen (16);
einen Datentreiber (12), der zum Erzeugen von Datenspannungen und Ausgeben der Datenspannungen an die Datenzeilen der Anzeigetafel konfiguriert ist;
einen Gatetreiber (13), der zum sequentiellen Zuführen eines Abtastimpulses zu den Abtastzeilen in Reaktion auf einen Gateschiebetakt konfiguriert ist; und eine Timingsteuerung,
das Verfahren aufweisend:
Aufteilen eines Frames in mehrere Subframes (SF1 bis SF6), Aufteilen von Daten eines Eingangsbilds an jedem Bit, und Abbilden der Daten des Eingangsbilds auf die mehreren Subframes, wobei jeder Subframe ein Bit der Daten des Eingangsbilds darstellt, wobei jede Abtastzeile der Anzeigetafel in einem Subframe derart adressiert wird, dass das Adressieren von Pixeln jeder Abtastzeile beinhaltet:
eine Datenadressierzeit (ADT), während welcher Datenspannungen auf die Pixel der Abtastzeile geschrieben werden; und
eine Emissionszeit (EMT), während welcher die Pixel (PXL) der Abtastzeile in Reaktion auf die geschriebenen Datenspannungen Licht emittieren; und
Synchronisieren der Betriebstimings der Ausgabe der Datenspannungen an die Datenzeilen und der sequentiellen Zufuhr des Abtastimpulses zu den Abtastzeilen,
**dadurch gekennzeichnet, dass** das Verfahren ferner das Anpassen einer Periode des Gateschiebetakts für mindestens einen Subframe des Frames aufweist, um dadurch die Datenadressiergeschwindigkeit des mindestens einen Subframes bezüglich der Datenadressiergeschwindigkeit des vorherigen Subframes des Frames anzupassen, wobei die Dauer der Datenadressierzeit (ADT) jeder Abtastzeile für den mindestens einen Subframe von jener der Datenadressierzeit (ADT) für jede Abtastzeile des vorherigen Subframes abweicht, und wobei die resultierenden Emissionszeiten (EMT) der oberen Abtastzeilen der Anzeigetafel für den vorherigen Subframe von den resultierenden Emissionszeiten der unteren Abtastzeilen der Anzeigetafel abweichen.

9. Verfahren nach Anspruch 8, wobei das Anpassen der Datenadressiergeschwindigkeiten das derartige Anpassen der Datenadressiergeschwindigkeit des mindestens einen Subframes der mehreren Subframes, dass sie von einem vorher festgelegten Bezugswert abweicht, beinhaltet.

10. Verfahren nach Anspruch 8, wobei, wenn eine Hochleistungsspannung (EVDD) zum Ansteuern der Pixel an die Anzeigetafel von einer Oberseite der Anzeigetafel angelegt und Datenadressierung sequentiell von der Oberseite zu einer Unterseite der Anzeigetafel folgezeilig ausgeführt wird, das Anpassen der Datenadressiergeschwindigkeiten das Reduzieren der Datenadressiergeschwindigkeit beinhaltet, wie sie von einem ersten Subframe zu einem letzten Subframe des einen Frames läuft,
wobei das signifikanteste Bit (MSB) der Daten auf den ersten Subframe abgebildet wird und das insignifikanteste Bit (LSB) der Daten auf den letzten Subframe abgebildet wird.

11. Verfahren nach Anspruch 8, wobei, wenn eine Hochleistungsspannung (EVDD) zum Ansteuern der Pixel an die Anzeigetafel von einer Unterseite der Anzeigetafel angelegt und Datenadressierung sequentiell von einer Oberseite zur Unterseite der Anzeigetafel folgezeilig ausgeführt wird, das Anpassen der Datenadressiergeschwindigkeiten das Erhöhen der Datenadressiergeschwindigkeit beinhaltet, wie sie von einem ersten Subframe zu einem letzten Subframe des einen Frames läuft,
wobei das signifikanteste Bit (MSB) der Daten auf den ersten Subframe abgebildet wird und das insignifikanteste Bit (LSB) der Daten auf den letzten Subframe abgebildet wird.

12. Verfahren nach einem der Ansprüche 8 bis 11, wobei das Anpassen der Datenadressiergeschwindigkeiten das Empfangen von mehreren Gateschiebetakten (GSC1 bis GSC4) mit verschiedenen Impulsperioden (P1 bis P4) und selektives Ausgeben von einem der mehreren Gateschiebetakte an den Gatetreiber (13) zur Startzeit von jedem Subframe beinhaltet.

13. Verfahren nach einem der Ansprüche 8 bis 12, wobei ein Dummy-Subframe ferner nach dem letzten Subframe in dem einen Frame angeordnet wird, und
wobei eine Länge des Dummy-Subframes an einer oberen Anzeigezeile der Anzeigetafel von einer Länge des Dummy-Subframes an einer unteren Anzeigezeile der Anzeigetafel abweicht.

14. Verfahren nach Anspruch 13, ferner aufweisend das Anlegen einer Datenspannung, die bewirkt, dass die Pixel kein Licht emittieren, während des Dummy-Subframes an die Anzeigetafel.

## Revendications

1. Dispositif d'affichage à diodes électroluminescentes organiques (OLED) comprenant :
un panneau d'affichage (10) comprenant une pluralité de pixels (PIX), une pluralité de lignes de données (15) et une pluralité de lignes de balayage (16) ;
un pilote de données (12) configuré pour générer des tensions de données et pour transmettre les tensions de données aux lignes de données du panneau d'affichage ;
un pilote de grille (13) configuré pour appliquer de manière séquentielle une impulsion de balayage aux lignes de balayage en réponse à une horloge de décalage de grille ; et
un dispositif de commande de synchronisation (11) configuré :
pour diviser une trame en une pluralité de sous-trames,
pour diviser des données d'une image d'entrée à chaque bit,
pour mettre en correspondance les données de l'image d'entrée avec la pluralité de sous-trames, chaque sous-trame représentant un bit des données de l'image d'entrée, la ligne de balayage du panneau d'affichage étant adressée dans une dite sous-trame de telle sorte que l'adressage des pixels de chaque ligne de balayage comprenne :
un temps d'adresse de données (ADT) pendant lequel des tensions de données sont écrites sur les pixels de ladite ligne de balayage ; et
un temps d'émission (EMT) pendant lequel les pixels (PXL) de la ligne de balayage émettent de la lumière en réponse auxdites tensions de données écrites ; et
pour commander un fonctionnement des pilotes de données et de grille, dans lequel le dispositif de commande de synchronisation est configuré pour synchroniser les temps de fonctionnement de la sortie desdites tensions de données avec lesdites lignes de données et la fourniture séquentielle de ladite impulsion de balayage avec lesdites lignes de balayage,
**caractérisé en ce que** le dispositif de commande de synchronisation est en outre configuré pour ajuster une période de ladite horloge de décalage de grille pour au moins une sous-trame de la trame pour ajuster, de ce fait, la vitesse d'adressage de données de ladite ou desdites sous-trames par rapport à la vitesse d'adressage de données de la précédente sous-trame de ladite trame, dans lequel la durée du temps d'adressage de données (ADT) de chaque ligne de balayage pour ladite ou lesdites sous-trames est différente de celle du temps d'adressage de données (ADT) pour chaque ligne de balayage de ladite précédente sous-trame, et, grâce à quoi, les temps d'émission résultants (EMT) des lignes de balayage supérieures du panneau d'affichage pour ladite précédente sous-trame sont différents des temps d'émission résultants (EMT) des lignes de balayage inférieures du panneau d'affichage.

2. Dispositif d'affichage à diodes électroluminescentes organiques selon la revendication 1, dans lequel le dispositif de commande de synchronisation ajuste la vitesse d'adressage de données de la ou des sous-trames de la pluralité de sous-trames de sorte à être différente d'une valeur de référence déterminée auparavant.

3. Dispositif d'affichage à diodes électroluminescentes organiques selon la revendication 1, dans lequel, lorsqu'une tension d'alimentation à potentiel élevé (EVDD) pour exciter les pixels est appliquée au panneau d'affichage à partir d'un côté supérieur du panneau d'affichage et qu'un adressage de données est effectué de manière séquentielle à partir du côté supérieur jusqu'à un côté inférieur du panneau d'affichage selon une manière linéaire séquentielle, le dispositif de commande de synchronisation réduit la vitesse d'adressage de données au fur et à mesure qu'elle passe d'une première sous-trame à une dernière sous-trame de la même trame,
dans lequel le bit le plus significatif (MSB) des données sera mis en correspondance avec la première sous-trame et le bit le moins significatif (LSB) des données sera mis en correspondance avec la dernière sous-trame.

4. Dispositif d'affichage à diodes électroluminescentes organiques selon la revendication 1, dans lequel, lorsqu'une tension d'alimentation à potentiel élevé (EVDD) pour exciter les pixels est appliquée au panneau d'affichage à partir d'un côté inférieur du panneau d'affichage et qu'un adressage de données est effectué de manière séquentielle à partir d'un côté supérieur jusqu'à un côté inférieur du panneau d'affichage selon une manière linéaire séquentielle, le dispositif de commande de synchronisation augmente la vitesse d'adressage de données au fur et à mesure qu'elle passe d'une première sous-trame à une dernière sous-trame de la même trame,
dans lequel le bit le plus significatif (MSB) des données sera mis en correspondance avec la première sous-trame et le bit le moins significatif (LSB) des données sera mis en correspondance avec la dernière sous-trame.

5. Dispositif d'affichage à diodes électroluminescentes organiques selon l'une quelconque des revendications 1 à 4, dans lequel le dispositif de commande de synchronisation comprend un multiplexeur (111) configuré pour recevoir une pluralité d'horloges de décalage de grille (GSC1 à GSC4) ayant des périodes d'impulsion différentes (P1 à P4) et pour transmettre de manière sélective une horloge de décalage de grille de la pluralité d'horloges de décalage de grille au pilote de grille (13) au moment de la synchronisation de démarrage de chaque sous-trame.

6. Dispositif d'affichage à diodes électroluminescentes organiques selon l'une quelconque des revendications 1 à 5, dans lequel une sous-trame factice (SF) est en outre disposée après la dernière sous-trame dans la même trame, et
dans lequel une longueur de la sous-trame factice au niveau d'une ligne d'affichage supérieure du panneau d'affichage est différente d'une longueur de la sous-trame factice au niveau d'une ligne d'affichage inférieure du panneau d'affichage.

7. Dispositif d'affichage à diodes électroluminescentes organiques selon la revendication 6, dans lequel le pilote de données (12) applique une tension de données, qui contraint les pixels à ne pas émettre de la lumière, au panneau d'affichage pendant la sous-trame factice.

8. Procédé pour exciter un dispositif d'affichage à diodes électroluminescentes organiques (OLED) comprenant un panneau d'affichage (10) comprenant : une pluralité de pixels (PIX), une pluralité de lignes de données (15) et une pluralité de lignes de balayage (16) ; un pilote de données (12) configuré pour générer des tensions de données et pour transmettre les tensions de données aux lignes de données du panneau d'affichage ;
un pilote de grille (13) configuré pour appliquer de manière séquentielle une impulsion de balayage aux lignes de balayage en réponse à une horloge de décalage de grille ; et un dispositif de commande de synchronisation,
le procédé consistant :
à diviser une trame en une pluralité de sous-trames (SF1 à SF6), à diviser des données d'une image d'entrée à chaque bit et à mettre en correspondance les données de l'image d'entrée avec la pluralité de sous-trames, chaque sous-trame représentant un bit des données de l'image d'entrée, chaque ligne de balayage du panneau d'affichage étant adressée dans une dite sous-trame de telle sorte que l'adressage des pixels de chaque ligne de balayage du panneau d'affichage comprenne :
un temps d'adresse de données (ADT) pendant lequel des tensions de données sont écrites sur les pixels de ladite ligne de balayage ; et
un temps d'émission (EMT) pendant lequel les pixels (PXL) de la ligne de balayage émettent de la lumière en réponse aux tensions de données écrites ; et
à synchroniser les temps de fonctionnement de la sortie desdites tensions de données avec lesdites lignes de données et la fourniture séquentielle de ladite impulsion de balayage avec lesdites lignes de balayage,
**caractérisé en ce que** le procédé consiste en outre à ajuster une période de ladite horloge de décalage de grille pour au moins une sous-trame de la trame pour ajuster, de ce fait, la vitesse d'adressage de données de ladite ou desdites sous-trames par rapport à la vitesse d'adressage de données de la précédente sous-trame de ladite trame, dans lequel la durée du temps d'adressage de données (ADT) de chaque ligne de balayage pour ladite ou lesdites sous-trames est différente de celle du temps d'adressage de données (ADT) pour chaque ligne de balayage de ladite précédente sous-trame, et, grâce à quoi, les temps d'émission résultants (EMT) des lignes de balayage supérieures du panneau d'affichage pour ladite précédente sous-trame sont différents des temps d'émission résultants des lignes de balayage inférieures du panneau d'affichage.

9. Procédé selon la revendication 8, dans lequel l'ajustement des vitesses d'adressage de données consiste à ajuster la vitesse d'adressage de données de la ou des sous-trames de la pluralité de sous-trames de sorte à être différente d'une valeur de référence déterminée auparavant.

10. Procédé selon la revendication 8, dans lequel, lorsqu'une tension d'alimentation à potentiel élevé (EVDD) pour exciter les pixels est appliquée au panneau d'affichage à partir d'un côté supérieur du panneau d'affichage et qu'un adressage de données est effectué de manière séquentielle à partir du côté supérieur jusqu'à un côté inférieur du panneau d'affichage selon une manière linéaire séquentielle, l'ajustement des vitesses d'adressage de données consiste à réduire la vitesse d'adressage de données au fur et à mesure qu'elle passe d'une première sous-trame à une dernière sous-trame de la même trame,
dans lequel le bit le plus significatif (MSB) des données sera mis en correspondance avec la première sous-trame et le bit le moins significatif (LSB) des données sera mis en correspondance avec la dernière sous-trame.

11. Procédé selon la revendication 8, dans lequel, lorsqu'une tension d'alimentation à potentiel élevé (EVDD) pour exciter les pixels est appliquée au panneau d'affichage à partir d'un côté inférieur du panneau d'affichage et qu'un adressage de données est effectué de manière séquentielle à partir d'un côté supérieur jusqu'à un côté inférieur du panneau d'affichage selon une manière linéaire séquentielle, l'ajustement des vitesses d'adressage de données consiste à augmenter la vitesse d'adressage de données au fur et à mesure qu'elle passe d'une première sous-trame à une dernière sous-trame de la même trame,
dans lequel le bit le plus significatif (MSB) des données sera mis en correspondance avec la première sous-trame et le bit le moins significatif (LSB) des données sera mis en correspondance avec la dernière sous-trame.

12. Procédé selon l'une quelconque des revendications 8 à 11, dans lequel l'ajustement des vitesses d'adressage de données consiste à recevoir une pluralité d'horloges de décalage de grille (GSC1 à GSC4) ayant des périodes d'impulsion différentes (P1 à P4) et à transmettre de manière sélective une horloge de décalage de grille de la pluralité d'horloges de décalage de grille au pilote de grille (13) au moment de la synchronisation de démarrage de chaque sous-trame.

13. Procédé selon l'une quelconque des revendications 8 à 12, dans lequel une sous-trame factice est en outre disposée après la dernière sous-trame dans la même trame, et
dans lequel une longueur de la sous-trame factice au niveau d'une ligne d'affichage supérieure du panneau d'affichage est différente d'une longueur de la sous-trame factice au niveau d'une ligne d'affichage inférieure du panneau d'affichage.

14. Procédé selon la revendication 13, consistant en outre à appliquer une tension de données, qui contraint les pixels à ne pas émettre de la lumière, au panneau d'affichage pendant la sous-trame factice.
